# EUROPEAN PATENT SPECIFICATION

(11) **EP 0 488 574 B1**
(45) Date of publication and mention of the grant of the patent: **08.11.1995**
(21) Application number: 91310677.9
(22) Date of filing: 20.11.1991
(51) Int. Cl.: B42D 15/02, G06K 19/06

(54) **Personal data card construction**
Aufbau einer Personaldatenkarte
Construction d'une carte de données individuelle

(30) Priority: 30.11.1990 US 620166
(43) Date of publication of application: 03.06.1992
(73) Proprietor: AT&T Corp., New York, NY 10013-2412 (US)
(72) Inventor: Flynn, Richard Michael, Indianapolis, Indiana 46220 (US); Verdi, Fred William Verdi, Lawrenceville, New Jersey 08648 (US)
(74) Representative: Johnston, Kenneth Graham

(56) References cited:
- US-A- 4 719 140
- US-A- 4 795 895
- US-A- 4 962 415

## Description

### Technical Field

This invention relates to a personal data card containing one or more electronic circuits and, more particularly, to the construction of same.

### Background of the Invention

Various manufacturers are presently engaged in the design of a personal data card, also known as a smart card, that looks and feels like a credit card but has the capabilities of a computer including the storage and processing of data. Smart cards have had some difficulty gaining acceptance because of cost and the lack of an application wherein the power of a computer plus the convenience of a credit card is mandated in a small portable device. If such an application existed, then issues such as cost, size and durability wouldn't be so critical to the wholesale deployment of smart cards. As it is, however, the key to smart card acceptance resides in developing one whose size allows it to be used interchangeably with conventional credit cards. Furthermore, smart cards need to be embossable and flexible without damage to frangible semiconductor chips embedded therein. Conventional credit card size is fixed by international agreement to 8.56, 5.4, 0.076 cms (3.370, 2.125, and 0.030 inches) for width, height, and thickness respectively. The International Organization for Standardization (ISO) has responsibility for promulgating a standard that stimulates international acceptance. However, building smart cards that meet ISO thickness and flexibility standards has proven to be a particularly intractable problem.

Presently, various manufacturers provide smart cards having a contact interface in which a conventional credit card is outfitted with a cavity that admits a pellet-like insert. The insert comprises electronic circuitry that is encapsulated in a suitably rigid, dielectric material. The pellet is then inserted into the cavity of the card and held therein by adhesive materials. For example, U.S. Patent 4,501,960 was issued to Jouvet et al. on February 26, 1985 and discloses a card of this general type. The insert comprises 12 flat metallic leads that extend from an encapsulated semiconductor chip. The leads are coated with an adhesive material, on one side, that attaches to the surface of a flexible plastic card. Flexing of the card, however, often causes the pellet to become dislodged, or causes one of the contacts to break away from the card. Furthermore, a smart card having metallic contacts on an outside surface is subject to contamination of its metallic leads, static discharge, and the application of improper voltages - all of which lead to unreliability.

Another example of a smart card having metallic contacts positioned on its surface is disclosed in U.S. Patent 4,649,418 which issued on March 10, 1987 to E. Uden. The Uden card comprises a polyvinyl chloride (PVC) card body having at least one aperture, sized to receive a structural member which takes the form of an epoxy glass circuit board. Within the structural member is a through-hole, sized to accommodate a semiconductor chip which has a set of pads thereon, each coupled by a wire lead to a corresponding metalized area on the structural member adjacent to the through-hole. A frame, formed of fiber-reinforced epoxy resin, is placed on the structural member about the through-hole to serve as a dam to contain epoxy encapsulant admitted into the through-hole in the structural member to seal the chip therein. Each of a pair of coverplates is attached to opposite sides of the card body to seal the structural member within the aperture of the card body. The Uden personal data card requires use of a frame to contain the encapsulant mass which often leads to an inability to maintain a cosmetically desirable, flat card surface.

Another example of a smart card is disclosed in U.S. Patent 4,921,160 issued on May 1, 1990, to the present inventors. Briefly, the '160 patent substantially overcomes the disadvantages of the Uden card by mounting a semiconductor chip within a recess in the card body that is supported by the bottom wall of the recess. A quantity of encapsulant is admitted into the recess to seal the chip therein. Further, a resilient, shock-absorbing device, comprising a ring or a plurality of ring segments of an elastomer (e.g. silicone rubber), is contained in the card body that substantially circumscribes the mass of encapsulant separating the encapsulant and chip contained therein from the bulk of the card body. The smart card includes a card body comprising a circuit board and a structural member bonded onto the surface of the circuit board by a layer of adhesive. Both the circuit board and the structural member are fabricated from a very high modulus material such as FR-4 or epoxy resin. Although this construction is an improvement over the Uden reference, is is desirable to provide additional improvements in the areas of reliability (due to chip fracture), embossing (per ISO standards), flexibility and cost.

Conventional credit cards are made from PVC because it is an inexpensive, durable material that is soft enough to be readily embossed. Unfortunately, PVC becomes too soft at temperatures used for curing adhesives typically used during lamination. Accordingly, is is desirable to select a material system for smart cards that simultaneously satisfies ISO size and flexibility standards, provides adequate protection for frangible semiconductors, allows embossing, and is capable of withstanding the high temperatures used to cure adhesives without adverse effect.

### Summary of the Invention

A personal data card which substantially overcomes the aforementioned disadvantages, comprises a lamination of sheets. The sheets include a polytester circuit board having a semiconductor chip mounted thereon; a polyester structural member having an opening which extends between the top and bottom surfaces of the structural member, for receiving the semiconductor chip; and label sheets positioned on the top and bottom of the card. The label sheets have matching thermal expansion characteristics. The semiconductor chip is contained within an encapsulant whose rigidity is greater than the structural member.

In the invention, the polyester material is heat-stabilized prior to lamination so that its thermal expansion characteristics will be same in all directions. Epoxy, which becomes extremely rigid after curing, is used as the encapsulant material. A cover, made from cloth that has been impregnated with epoxy, overlays the opening in the structural member to provide improved support for the semiconductor chip contained therein.

The circuit board comprises the same polyester material used in the structural member and helps prevent the personal data card from warping (i.e., changing its generally flat shape) due to changes in temperature. Similarly, the label sheets positioned on the top and bottom of the card are made from thermopolastic materials which may be different than polyester. Warpage is avoided because the effect of one is canceled by the other. In a preferred embodiment, the label sheets are made from polyvinyl chloride. Lateral stresses that would otherwise be transmitted to the semiconductor chip are absorbed within the structural member because it is substantially more flexible than the epoxy which surrounds the chip.

### Brief Description of the Drawing

The invention and its mode of operation will be more clearly understood from the following detailed description when read with the appended drawing in which:
FIG. 1 is an exploded, perspective view of a personal data card illustrating its general construction in accordance with the invention;
FIG. 2 is an exploded, cross-section view of the personal data card showing its individual sheets in greater detail; and
FIG. 3 is a partially cut away, perspective view of the assembled personal data card showing the various sheets and illustrative thicknesses associated with each sheet.

### Detailed Description

In spite of their ability to store and process large quantities of data, which is highly desirable in our information-intensive society, smart card acceptance has been very slow - particularly in countries where private enterprise, rather than government subsidy, must absorb start-up costs. Competing with smart cards are conventional magnetic-stripe credit cards which are relatively inexpensive and durable, although the actual magnetic stripe is very sensitive to erasure due to stray magnetic fields from: magnetic purse catches, I.D. pouches, motors, TVs and radios. Nevertheless, in the absence of an important new use that absolutely demands the power of a smart card, their acceptance will probably occur only when they are interchangeable with conventional cards and carry a minimum cost premium. Semiconductor costs are decreasing at an impressive rate and it is clear that cost itself is not destined to be the major factor; so the key to smart card acceptance now appears to depend on whether it can be constructed with the same dimensions as the conventional card, and whether these dimensions afford sufficient protection to frangible semiconductor chips embedded therein.

### International Standards

The International Organization for Standardization (ISO) is a worldwide federation of national standards bodies. They have promulgated standards for conventional magnetic-stripe cards that relate to warpage, embossability and dimensions to name but a few. Nominal dimensions for width, height and thickness respectively are (85, 53, 0.76 mm) which convert to (3.370, 2.125, 0.030 inches). The thickness dimension 0.076 cms (30 mils,) has been particularly difficult for smart cards to achieve. Smart cards are subject to additional requirements related to dynamic bending stress about two axes, dynamic torsion stress, static electricity, vibration, electromagnetic fields and others. These requirements have been most difficult to achieve because various materials and processes are incompatible with each other. The problem is further complicated when manufactured cost and drop-out rate are considered. A smart card referred to as a personal data card, constructed in accordance with the principles of the present invention not only meets ISO standards, but does so at a cost that, for the first time, brings smart cards into meaningful consideration as a replacement for the conventional magnetic-stripe card - at least as a premium ("gold" or "platinum") card.

The present invention improves the concept developed in our prior U.S. Patent 4,921,160 which surrounds a semiconductor chip with a shock-absorbing ring. The ring comprises an elastomer (e.g., silicone rubber) that decouples the chip from stress created by flexing the card body. This concept is expanded in the present invention by making the entire card body more flexible so that it functions as a large elastomer ring. Whereas the card body of our '160 patent was made from conventional glass epoxy board material, the present invention uses heat-stabilized polyester.

### General Construction

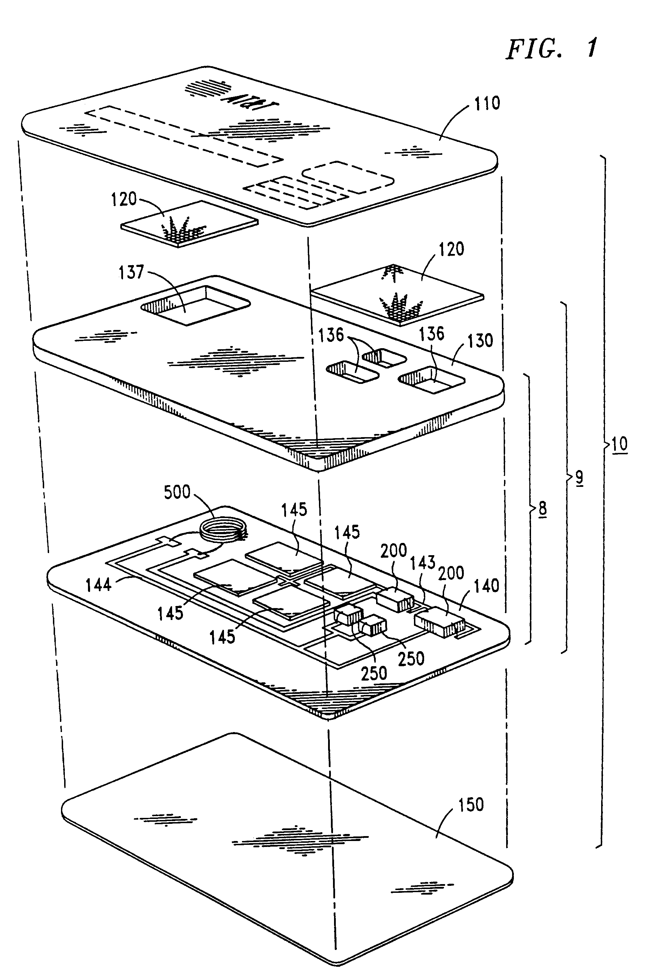

FIG. 1 shows an exploded perspective view of a personal data card in accordance with the invention. Card 10 is a contactless smart card that houses frangible semiconductor chips 200 in a laminated structure that protects them from stress due to flexing and from exposure to external contaminants. Semiconductor chips 200 provide the capabilities of a computer within a small portable device. Power for the chips is inductively coupled to the coil 500 in the manner disclosed in U.S. Patent 4,802,080 issued to B.J. Bossi et al. on January 31, 1989. Bidirectional data transfer is achieved using four capacitors 145 - one pair being used for transmitting data and the other pair being used for receiving data.

Assembly 8, shown in FIG. 1, comprises circuit board 140 and structural member 130 which are made from the same type of material so that when subjected to changes in temperature they will shrink or expand at the same rate and thereby avoid warping. Thus, the card remains generally flat at all temperatures as required by ISO standards. Advantageously, structural member 130 is made from heat-stabilized polyester material which is discussed below. Openings 136,137 are created by stamping through-holes in structural member 130. Metallized areas 143-145 are created on circuit board 140 by etching. These two parts are then joined together in a first lamination process which comprises heating to 105° C for 13 minutes at 980,000 Pa (140 PSI.) After cooling, components 200, 250, 500 are mounted onto the circuit board 140 through openings 136, 137 in the structural member 130. Assembly 8 is now ready to receive encapsulant materials which enhance the performance and durability of the personal data card 10.

A slurry of ferrite particles and flexible epoxy is now poured into opening 137 and surrounds wire coil 500. After the slurry cures it remains flexible and operates to enhance the transfer of electrical power to coil 500. Reference is made to U.S. Patent 4,692,604 which discusses the benefits of a flexible magnetic core piece that assists coil 500 in functioning as the secondary portion of a power transformer. Since coil 500 flexes without damage, there is no advantage in surrounding it with a rigid encapsulant to prevent it from flexing. On the other hand, an epoxy encapsulant is poured into opening 136 which becomes extremely rigid when cured and thus prevents fragile components 200, 250 from cracking when the card is flexed. Indeed, the rigidity of the epoxy encapsulant cooperates with the flexibility of structural member 130 to achieve this protection. Frangible semiconductor chip 200 is the primary beneficiary of this cooperation. Also cooperating to protect the encapsulated components are covers 120 which comprise sheets of cloth that have been impregnated with partially-cured (B-staged) epoxy. Covers 120 are referred to as "Prepreg" which is commercially available from a number of suppliers including the General Electric Company. Assembly 9 is now ready for curing which comprises heating to 165° C for 45 minutes at 350,000 Pa (50 PSI.) Assembly 9 is frequently referred to as a "smart core" which is suitable for shipping to any one of a number of card issuers.

Finally, label sheets 110, 150 are made from a thermoplastic material and are positioned on the top and bottom surfaces of the card 10 to protect the electronic circuitry and the metallic paths on circuit board 140 from static discharge and external contaminants. It is important that the labels have matching thermal expansion characteristics. In the preferred embodiment, label sheets 110, 150 are each made from PVC and have a thickness of 0.00254 cms (0.001 inch (1 mil)). Each label is subsurface printed and coated with a heat-activated adhesive on one side. The assembled card 10 is then subjected to increased temperature (150° C) and pressure 700,000 Pa (100 PSI) for a period of time (10 minutes) in order to activate the adhesive.

The card issuer typically adds the cover label and embossing in a secure facility to safeguard against card theft and forgery. The fully assembled card 10 is now ready for use after suitable programming and testing of semiconductor chips 200 which illustratively comprise a microprocessor and Electrically Erasable and Programmable Read Only Memory (EEPROM). Security information, such as passwords for accessing certain files, can be entered into the memory of the card at this time also.

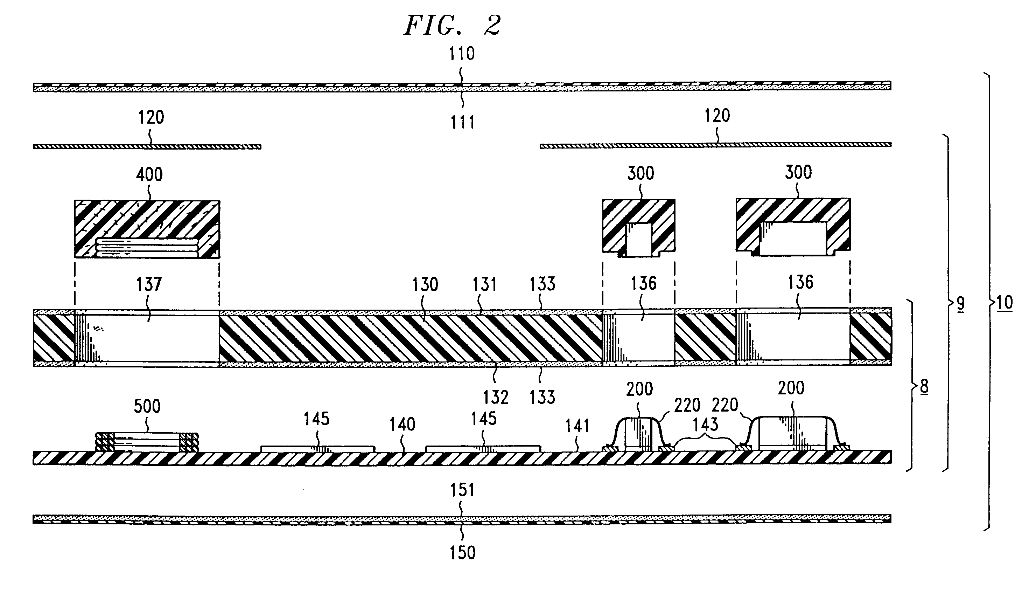

FIG. 2 is an exploded cross-section view of a preferred embodiment of a personal data card showing the various sheets that cooperate in providing a durable card that meets ISO standards in a cost-effective manner. FIG. 2 also illustrates the approximate relative dimensions of the various sheets. Because the preferred embodiment comprises a contactless card, the top and bottom sheets 110, 150 are without openings so that circuitry within the card receives substantial protection. Greater protection can be achieved by doubling the thickness of sheets 110, 150 to 0.0051 cms (2 mils) each. However, to continue satisfying ISO standards, another of the sheets would need to be decreased in thickness. Heat-activated adhesives 111, 151 are applied to thermoplastic sheets 110, 150 before they are cut to "credit card" size. Indeed, for convenience, a large number of personal data cards are initially joined together in a single laminated structure before individual ones are stamped out. It is noted that adhesive layer 111 is 0.0051 cms (2 mils) thick while adhesive layer 151 is only 0.0025 cms (1 mil) thick. The thickness of adhesive layer 111 is intended to "smooth out" any bumps on the top surface 131 of structural member 130 created by covers 120. These covers serve to protect the encapsulated components within openings 136, 137 of structural member 130.

Encapsulants 300, 400 are shown removed from through-holes 136, 137 whereas in reality they surround components 200, 500 respectively. For convenience of manufacture and assembly, structural member 130 includes a layer of heat-activated adhesive 133 on the top surface 131 and bottom surface 132 thereof. Such adhesives are dry at room temperature which allows for easy handling. They do not become sticky until sufficient heat is applied. During the first stage of lamination, adhesive 133 on the bottom surface 132 of the structural member 130 functions to bond the structural member to the top surface 141 of circuit board 140. Thereafter, semiconductor chips 200 are bonded to metallized areas 143 on circuit board 140 via wires 220. Such construction has been found to provide highly reliable electrical connections. The chips 200 are placed by machine onto circuit board 140 and are initially held there by an adhesive.

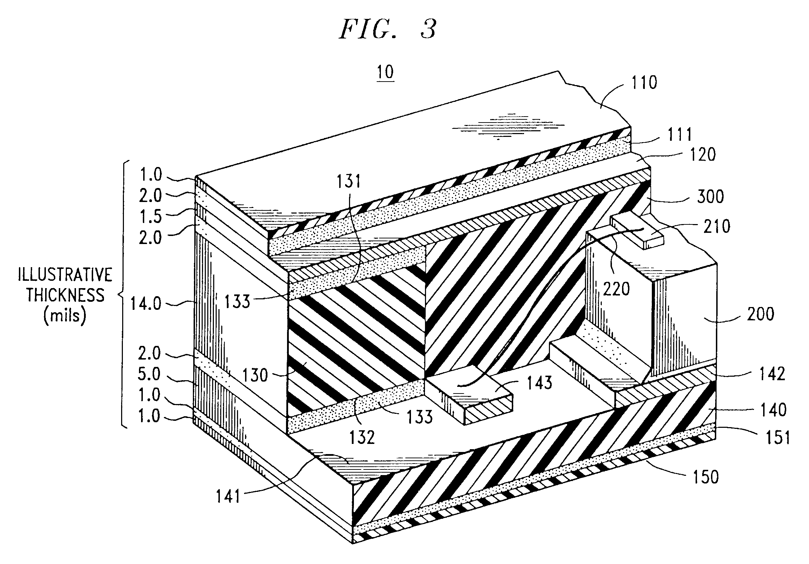

FIG. 3 represents a perspective view of the assembled personal data card 10 showing illustrative values for the thickness of each sheet. At least one semiconductor chip 200, typically a memory chip or the combination of a memory and microprocessor chip, has its undersurface secured to metallized area 142. The chip has a plurality of conductive pads 210, usually on top, which are each selectively coupled by a separate one of a set of small diameter wires 220 to a separate one of the metallized pads 143 on the top surface of circuit board 140. Each wire typically has a small loop (not shown) near the end thereof connected to the pad 210 on the chip 200 to provide the wire a small degree of strain relief. The loop is sized so as to lie below the top of the structural member 130. It should be noted that wires 220 are not the only mechanism by which the chip 200 can be electrically connected to circuit board 140. Other well-known techniques, such as tab bonding and flip chip bonding, can also be used for making electrical connections.

### Materials

Of particular significance are the specific materials used in the construction of the personal data card, particularly structural member 130 which is a polyester film having a nominal thickness of 0.0356 cms (14 mils.). Certain advantages are associated with the use of polyester that make it an excellent choice for a personal data card. It is a flexible, dielectric material that is less expensive than kapton or polyimide and it embosses better. Further, unlike PVC, it does not become too soft during the high temperature lamination process. For this reason, soldering to a PVC circuit board is not desirable. Polyester films are extruded at relatively high temperatures, and are subject to dimensional change as a function of temperature. The polyester film emerges from an extruding machine in a direction that is known as its machine direction (MD). The other direction of this generally-planar film is known as its transverse direction (TD). It is important to note that the resulting, untreated polyester film tends to shrink to a greater extent in the machine direction than in the transverse direction upon application of heat. A process known as heat-stabilization is employed to reduce the relative rate of thermal expansion in these two directions. A typical heat-stabilization process for 14 mil polyester comprises raising the temperature of the polyester film to 150° C for some predetermined time interval. This process greatly reduces dimensional changes in the polyester material in all directions. An acceptable value for shrinkage of the structural member used in the present invention is: MD and TD shrinkage of less than 0.2% unrestrained at 150° C for 30 minutes. So that warpage does not occur, both the structural member and the circuit board are made from similar materials, namely polyester.

Polyester material is commercially available in different thickness from a number of suppliers. Additionally, it is marketed under various trade names including MYLAR™, PHANEX™, MELINEX™ - depending on the particular supplier. Polyester material used for the structural (strength) member 130 has a thickness of 0.0356 cms (0.014 inches (14 mils)) which, when coated with 2 mils of heat-activated adhesive on each side, is greater than the height of the semiconductor chip. Thus, the chip does not protrude above the through-hole in the structural member when the circuit board and the structural member are joined.

For the purpose of the present invention the term "polyester" refers to any of a group of thermoplastic polyester materials which primarily include, but are not limited to, the polyethylene terephthalate (PET) and the polybutylene terephthalate (PBT) families. In a preferred embodiment of the invention, PET materials are used.

After the polyester structural member 130 has been heat stabilized, it is coated with a heat-activated adhesive 133 on its top surface 131 and bottom surface 132 (see FIG. 2). A suitable adhesive for use on polyester film is A412 which is available from sheldahl, Inc. Advantageously, this adhesive is flame retardant and can be heat sealed with a hot nip roll at about 177°C (350°F) at 560,000 to 700,000 Pa (80-100 pli) or platen pressed at 135°C to 149°C (275° - 300°F), at 700,000 to 1,400,000 Pa (100 - 200 psi) for 10 minutes and cooled under pressure to 38°C (100°F).

Circuit board 140 is a composite of a copper foil conductor bonded to the top surface 141 (see FIG. 2) of a polyester film dielectric. Such laminates are frequently used for flexible wiring and interconnects, and are compatible with standard etch processes. A thickness in the polyester material of 0.0127 cms (0.005 inches (5 mils)) is used in the preferred embodiment, although thineer materials 0.0076 cms (e.g. 3 mils) may be used with acceptable results. Commercially-available materials include the L-5500 Polyester Base Flexible Electrical Laminates from Sheldahl, Inc.

## Claims

1. A personal data card (10) of laminated construction **characterized by** a circuit board (140) primarily comprising heat-stabilized polyester material having a semiconductor chip (200) mounted on the top surface thereof;
a structural member (130) primarily comprising heat-stabilized polyester material, the member having an opening (136) therein which receives the semiconductor chip (200), the opening extending from the top surface of the structural member to the bottom surface thereof, the bottom surface of the structural member (130) being attached to the top surface of the circuit board (140);
a mass of encapsulant (300), admitted into the opening (136) in the top surface of the structural member (130) and sealing the chip (200) therein, said encapsulant being more rigid than the structural member (130); and
first and second polyvinyl chloride sheets (110, 150) attached on the top and bottom surfaces of the personal data card (10).

2. The personal data card (10) of claim 1 wherein the polyester material comprises polyethylene terephthalate.

3. The personal data card (10) of claim 1 further including a cover sheet (120), comprising an epoxy-impregnated cloth, covering a portion of the top surface (131) of the structural member (130) in the region of the opening (136).

4. The personal data card (10) of claim 1 wherein the structural member (130) includes heat-activated adhesive (133) on its top and bottom surfaces (131, 132).

5. The personal data card (10) of claim 1 wherein the encapsulant (300) is made from epoxy material.

6. The personal data card (10) of claim 1 wherein the first and second polyvinyl chloride sheets (110, 150) have the same thickness.

7. The personal data card (10) of claim 1 wherein the polyvinyl chloride sheets (110, 150) each include heat-activated adhesive (111, 151) on one surface thereof.

8. The personal data card (10) of claim 1 wherein the polyester structural member (130) has a thickness of approximately 0.36 mm (0.014 inches).

9. The personal data card (10) of claim 8 wherein approximately 0.05 mm (0.002 inches) of heat-activated adhesive (133) are applied to each surface of the polyester structural member (130).

10. The personal data card (10) of claim 1 wherein the circuit board (140) has a thickness of approximately 0.127 mm (0.005 inches) or less.

11. The personal data card (10) of claim 1 wherein the polyvinyl chloride sheets (110,150) each have a thickness of approximately 0.025 mm (0.001 inches).

12. The personal data card (10) of claim 3 wherein the cloth (120) has a thickness of approximately 0.038 mm (0.0015 inches).

13. A method for assembling a personal data card (10) comprising the following steps:
etching wiring paths (144) on a generally flat, heat-stabilized polyester film that has been coated with a thin metallic layer to form a circuit board (140);
mounting at least one semiconductor chip (200) on the circuit board (140);
joining the circuit board (140) to a generally flat strength member (130) primarily comprising a heat-stabilized polyester film whose thickness exceeds the height of the semiconductor above the circuit board, the strength member having a through-hole for receiving the semiconductor (200) and having adhesive material (133) on its top and bottom surfaces;
injecting an epoxy encapsulant (300) into the through-hole (136) to provide added rigidity to the semiconductor chip (200);
joining a sheet of polyvinyl chloride material (110,150) to the top and bottom surfaces of the circuit board/strength member (140/130) assembly, the polyvinyl chloride sheets having adhesive material (111,151) on one side thereof; and
applying heat and pressure to the assembled personal data card for a period of time sufficient to bond the various materials into a unitary structure (10).

14. The method of claim 13 further including the step of:
covening the through-hole (136) in the strength member (130) with a cloth (120) that has been impregnated with partially-cured epoxy (B-staged) after the epoxy encapsulant has been injected therein.

## Patentansprüche

1. Geschichtet aufgebaute Personendatenkarte (10), gekennzeichnet durch
eine in erster Linie aus wärmestabilisiertem Polyestermaterial bestehende Leiterplatte (140), auf deren Oberseite ein Halbleiterplättchen (200) befestigt ist;
ein in erster Linie aus wärmestabilisiertem Polyestermaterial bestehendes Konstruktionsteil (130) mit einer Öffnung (136), die das Halbleiterplättchen (200) aufnimmt und sich von der Oberseite des Konstruktionsteils bis zu dessen Unterseite erstreckt, wobei die Unterseite des Konstruktionsteils (130) an der Oberseite der Leiterplatte (140) angebracht ist;
eine Masse eines in die Öffnung (136) in der Oberseite des Konstruktionsteils (130) eingelassen wird Vergußmittels (300), das das Plättchen (200) darin versiegelten und starrer ist als das Konstruktionsteil (130); sowie
eine erste und zweite Polyvinylchloridfolie (110, 150), die an der Ober- bzw. Unterseite der Personendatenkarte (10) angebracht sind.

2. Personendatenkarte (10) nach Anspruch 1, wobei das Polyestermaterial Polyethylenterephthalat beinhaltet.

3. Personendatenkarte (10) nach Anspruch 1, die weiterhin eine ein epoxygetränktes Gewebe beinhaltende Deckfolie (120) aufweist, die einen Teil der Oberseite (131) des Konstruktionsteils (130) im Bereich der Öffnung (136) abdeckt.

4. Personendatenkarte (10) nach Anspruch 1, wobei das Konstruktionsteil (130) auf seiner Ober- bzw. Unterseite (131, 132) wärmeaktivierten Klebstoff (133) enthält.

5. Personendatenkarte (10) nach Anspruch 1, bei der das Vergußmittel (300) aus Epoxymaterial besteht.

6. Personendatenkarte (10) nach Anspruch 1, bei der die erste und zweite Polyvinylchloridfolie (110, 150) die gleiche Dicke aufweisen.

7. Personendatenkarte (10) nach Anspruch 1, bei der die Polyvinylchloridfalien (110, 150) jeweils auf einer ihrer Oberflächen wärmeaktivierten Klebstoff (111, 151) enthalten.

8. Personendatenkarte (10) nach Anspruch 1, bei der das Poylesterkonstruktionsteil (130) eine Dicke von ca. 0,36 mm (0,014 Zoll) aufweist.

9. Personendatenkarte (10) nach Anspruch 8, bei der ca. 0,05 mm (0,002 Zoll) an wärmeaktiviertem Klebstoff (133) auf jede Seite des Polyesterkonstruktionsteils (130) aufgetragen werden.

10. Personendatenkarte (10) nach Anspruch 1, wobei die Leiterplatte (140) eine Dicke von ca. 0,127 mm (0,005 Zoll) oder weniger aufweist.

11. Personendatenkarte (10) nach Anspruch 1, bei der die Polyvinylchloridfolien (110, 150) jeweils eine Dicke von ca. 0,025 mm (0,001 Zoll) aufweisen.

12. Personendatenkarte (10) nach Anspruch 3, wobei das Gewebe (120) eine Dicke von ca. 0,038 mm (0,0015 Zoll) aufweist.

13. Verfahren zum Zusammenfügen einer Personendatenkarte (10), das die folgenden Schritte umfaßt:
auf einer weitgehend ebenen, wärmestabilisierten, mit einer dünnen metallischen Schicht beschichteten Polyesterfolie werden Leiterzüge (144) geätzt, wodurch eine Leiterplatte (140) gebildet wird;
mindestens ein Halbleiterplättchen (200) wird auf der Leiterplatte (140) befestigt;
die Leiterplatte (140) wird mit einem weitgehend ebenen Armierungselement (130) verbunden, das in erster Linie aus einer wärmestabiliserten Polyesterfolie besteht, deren Dicke größer ist als die Höhe des Halbleiters über der Leiterplatte, wobei das Armierungselement ein Durchgangsloch zur Aufnahme des Halbleiters (200) besitzt und an seiner Ober- bzw. Unterseite Klebstoff (133) aufweist;
ein Epoxyvergußmittel (300) wird in das Durchgangsloch (136) eingespritzt, um das Halbleiterplättchen (200) zusätzlich zu versteifen;
eine Folie aus Polyvinylchloridmaterial (110, 150) wird mit der Ober- bzw. Unterseite des Aufbaus aus Leiterplatte/Armierungselement (140/130) verbunden, wobei die Polyvinylchloridfolien auf einer Seite mit Klebstoff (111, 151) versehen sind; und
die zusammengefügte Personendatenkarte wird solange hitze- und druckbeaufschlagt, bis die verschiedenen Materialien zu einem einheitlichen Aufbau (10) verklebt sind.

14. Verfahren nach Anspruch 13, bei dem als weiterer Schritt das Durchgangsloch (136) im Armierungselement (130) nach dem Einspritzen des Epoxyvergußmittels in dasselbe mit einem mit teilweise gehärtetem Epoxydharz (im B-Zustand) getränkten Gewebe (120) abgedeckt wird.

## Revendications

1. Carte de données individuelle (10) de construction feuilletée caractérisée par une carte de circuit (140) comprenant essentiellement une matière de polyester stabilisée à la chaleur ayant une puce de semiconducteur (200) montée sur la surface supérieure de celle-ci;
un élément structurel (130) comprenant essentiellement une matière de polyester stabilisée à la chaleur, l'élément ayant une ouverture (136) qui reçoit la puce de semiconducteur (200), l'ouverture allant de la surface supérieure de l'élément structurel jusqu'à la surface inférieure de celui-ci, la surface inférieure de l'élément structurel (130) étant fixée à la surface supérieure de la carte de circuit (140);
une masse de matière d'enrobage (300), admise dans l'ouverture (136) dans la surface supérieure de l'élément structurel (130) et scellant la puce (200) dans celle-ci, ladite matière d'enrobage étant plus rigide que l'élément structurel (130); et
des première et deuxième feuilles de chlorure de polyvinyle (110, 150) fixées sur les surfaces supérieure et inférieure de la carte de données individuelle (10).

2. Carte de données individuelle (10) selon la revendication 1, dans laquelle la matière de polyester comprend du polytéréphtalate d'éthylène.

3. Carte de données individuelle (10) selon la revendication 1, comprenant en outre une feuille de couverture (120), comprenant un tissu imprégné d'époxy, couvrant une partie de la surface supérieure (131) de l'élément structurel (130) dans la région de l'ouverture (136).

4. Carte de données individuelle (10) selon la revendication 1, dans laquelle l'élément structurel (130) comprend un adhésif activé à la chaleur (133) sur ses surfaces supérieure et inférieure (131, 132).

5. Carte de données individuelle (10) selon la revendication 1, dans laquelle la matière d'enrobage (300) est faite à partir d'une matière d'époxy.

6. Carte de données individuelle (10) selon la revendication 1, dans laquelle les première et deuxième feuilles de chlorure de polyvinyle (110, 150) ont la même épaisseur.

7. Carte de données individuelle (10) selon la revendication 1, dans laquelle les feuilles de chlorure de polyvinyle (110, 150) comportent chacune un adhésif activé à la chaleur (111, 151) sur l'une de leurs surfaces.

8. Carte de données individuelle (10) selon la revendication 1, dans laquelle l'élément structurel de polyester (130) a une épaisseur d'environ 0,36 mm (0,014 pouces).

9. Carte de données individuelle (10) selon la revendication 8, dans laquelle environ 0,05 mm (0,002 pouces) d'adhésif activé à la chaleur (133) sont appliqués sur chaque surface de l'élément structurel de polyester (130).

10. Carte de données individuelle (10) selon la revendication 1, dans laquelle la carte de circuit (140) a une épaisseur d'environ 0,127 mm (0,005 pouces) ou moins.

11. Carte de données individuelle (10) selon la revendication 1, dans laquelle les feuilles de chlorure de polyvinyle (110, 150) ont chacune une épaisseur d'environ 0,025 mm (0,001 pouces).

12. Carte de données individuelle (10) selon la revendication 3, dans laquelle le tissu (120) a une épaisseur d'environ 0,038 mm (0,0015 pouces).

13. Méthode d'assemblage d'une carte de données individuelle (10) comprenant les opérations suivantes:
gravure par attaque chimique de lignes de métallisation (144) sur une pellicule de polyester stabilisée à la chaleur, généralement plate qui a été revêtue d'une fine couche métallique pour former une carte de circuit (140);
montage d'au moins une puce de semiconducteur (200) sur la carte de circuit (140);
raccordement de la carte de circuit (140) à une armature généralement plate (130) comprenant essentiellement une pellicule de polyester stabilisée à la chaleur dont l'épaisseur dépasse la hauteur du semiconducteur au-dessus de la carte de circuit, l'armature ayant un trou traversant pour recevoir le semiconducteur (200) et ayant une matière adhésive (133) sur ses surfaces supérieure et inférieure;
injection d'une matière d'enrobage d'époxy (300) dans le trou traversant (136) pour apporter une rigidité supplémentaire à la puce de semiconducteur (200);
raccordement d'une feuille de matière de chlorure de polyvinyle (110, 150) aux surfaces supérieure et inférieure de l'ensemble carte de circuit/élément structurel (140/130), les feuilles de chlorure de polyvinyle ayant une matière adhésive (111, 151) sur l'un de leurs côtés; et
application de chaleur et de pression à la carte de données individuelle assemblée pendant une période de temps suffisante pour souder les diverses matières en une structure unitaire (10).

14. Méthode selon la revendication 13, comportant en outre l'opération de:
recouvrement du trou traversant (136) dans l'armature (130) avec un tissu (120) qui a été imprégné d'époxy partiellement vulcanisée (à l'état B) après que la matière d'enrobage d'époxy y ait été injectée.
